Europäisches Patentamt

European Patent Office

Office européen des brevets

(19)

(11) Veröffentlichungsnummer: **0 031 427**
**B1**

(12) **EUROPÄISCHE PATENTSCHRIFT**

(45) Veröffentlichungstag der Patentschrift: **18.02.87**

(51) Int. Cl.⁴: **H 01 G 4/30,** H 01 G 1/147

(21) Anmeldenummer: **80106924.6**

(22) Anmeldetag: **10.11.80**

(54) Dickschicht-Kondensator.

(30) Priorität: **26.12.79 US 106640**

(43) Veröffentlichungstag der Anmeldung:
**08.07.81 Patentblatt 81/27**

(45) Bekanntmachung des Hinweises auf die
Patenterteilung:
**18.02.87 Patentblatt 87/08**

(84) Benannte Vertragsstaaten:
**DE FR GB IT**

(56) Entgegenhaltungen:
**FR-A-1 280 454**
**GB-A-1 270 470**
**US-A-3 308 359**

(73) Patentinhaber: **International Business Machines
Corporation
Old Orchard Road
Armonk, N.Y. 10504 (US)**

(72) Erfinder: **Feinberg, Irving
13 Meadow View Dr.
Poughkeepsie, N.Y. 12603 (US)**
Erfinder: **Wu, Leon Li-Heng
Dogwood Road
Hopewell Junction, N.Y. 12533 (US)**

(74) Vertreter: **Gaugel, Heinz, Dipl.-Ing.
Schönaicher Strasse 220
D-7030 Böblingen (DE)**

Courier Press, Leamington Spa, England.

EP 0 031 427 B1

**Beschreibung**

Die Erfindung bezieht sich auf einen Dickschicht-Kondensator mit mehreren, jeweils durch eine dielektrische Schicht getrennten, leitenden Platten, von denen die einen mit einem ersten Anschluß und die anderen mit einem zweiten Anschluß verbunden sind.

Verwendet werden derartige Kondensatoren beispielsweise zum Zwecke der Störsignalausblendung bei schnellen, hochintegrierten logischen Schaltungsmoduln. Dabei bewirken diese Kondensatoren, daß die durch die Schaltvorgänge hervorgerufenen Störsignale nicht über die gemeinsame Spannungsversorgung auf die einzelnen Moduln gekoppelt werden. Für solche Entkopplungs-Kondensatoren wird eine extrem niedrige interne Induktivität verlangt, da nur bei einer niedrigen internen Induktivität ein schnelles Laden und Entladen gewährleistet ist.

Konventionelle Dickschicht-Kondensatoren, also Kondensatoren mit relativ dicken dielektrischen Schichten in der Größenordnung von 25 bis 80 μm und einer hohen Dielektrizitätskonstanten von etwa 100, sind relativ billig herzustellen und weisen eine hohe Zuverlässigkeit auf. Nachteilig ist jedoch, daß diese Dickschicht-Kondensatoren eine hohe interne Induktivität aufweisen.

Konventionelle Dünnschicht-Kondensatoren sind dagegen relativ teuer und nicht in dem gleichen Maße zuverlässig, aber sie weisen eine relativ niedrige interne Induktivität auf.

Aus der Us Patentschrift 3 308 359 ist ein zyklischer Kondensator mit mehreren, jeweils durch eine dielektrische Schicht getrennten, koaxialen, leitenden Kondensatorplatten bekannt, von denen die einen mit einem ersten Anschluß und die anderen mit einem zweiten Anschluß verbunden sind. Der erste Anschluß besteht aus einer ersten und der zweite Anschluß aus einer zweiten, von der ersten durch eine Isolationsschicht getrennten, leitenden Schicht. Die beiden Schichten erstrecken sich im wesentlichen senkrecht zu den Kondensatorplatten. Die Kondensatorplatten sind jeweils über die gleiche Kante mit der ersten bzw. zweiten leitenden Schicht leitend verbunden.

Auf diese Weise erzielt man eine niedrige interne Induktivität, da die im Betrieb auftretenden Verschiebungsströme in jeweils benachbarten Kondensatorplatten in entgegengesetzter Richtung fließen. Es sind jedoch keine Vorkehrungen getroffen, die notwendigen, leitenden Verbindungen zwischen den Kanten der Kondensatorplatten und den die Anschlüsse bildenden leitenden Schichten induktivitätsarm auszugestalten.

Hier will die Erfindung Abhilfe schaffen. Die Erfindung, wie sie in den Ansprüchen gekennzeichnet ist, löst die Aufgabe, einen Dickschicht-Kondensator zu verwirklichen, der insgesamt eine niedrige interne Induktivität aufweist und gleichzeitig die Vorteile der konventionellen Dickschicht-Kondensatoren behält.

Zusammengefaßt dargestellt ist der Dickschicht-Kondensator aufgebaut aus einem Stapel dielektrischer Schichten, die mit metallischen Schichten als Kondensatorplatten belegt sind. Die Kondensatorplatten sind jeweils über den gleichen Rand abwechselnd mit einem ersten oder einem zweiten Anschluß verbunden, so daß die im Betrieb auftretenden Verschiebungsströme in jeweils benachbarten Kondensatorplatten in entgegengesetzter Richtung fließen und damit eine niedrige interne Induktivität des Kondensators gewährleisten. Die Kondensatorplatten können in Gruppen zusammengefaßt und gruppenweise an die beiden Anschlüsse geführt sein.

Im folgenden wird die Erfindung anhand von lediglich einen Ausführungsweg darstellenden Zeichnungen näher erläutert.

Es zeigen:

Fig. 1 eine perspektivische Ansicht eines erfindungsgemäßen Kondensators,

Fig. 1A eine vergrößerte Teilansicht des in Fig. 1 gestrichelt angedeuteten Teils des Kondensators,

Fig. 2 eine Explosionsansicht eines Teils des Kondensators nach Fig. 1A,

Fign. 3A und 3B die Herstellung einer der in den Fign. 1, 1A und 2 verwendeten Schichten und

Fig. 4 eine Schnittansicht des mehrlagigen Anschlusses der Kondensatorplatten.

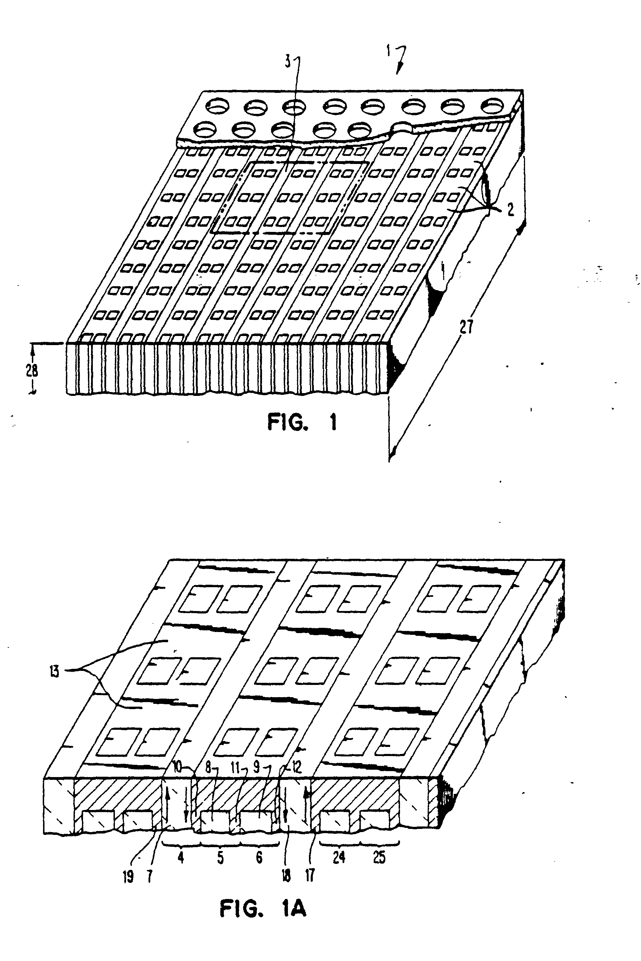

Der kondensator 1 gemäß Fig. 1 umfaßt einen Stapel senkrecht angeordneter, mit einer leitenden Schicht belegter Platten aus keramischem Material. Diese Platten sind in Gruppen miteinander verbunden über Gebiete 2 aus leitendem Material, die in die oberen Ränder der Platten eingebettet sind. Der genauere Aufbau des Kondensators ergibt sich aus der Fig. 1A, die den Vergrößert dargestellten Bereich 3 aus der Fig. 1 umfaßt.

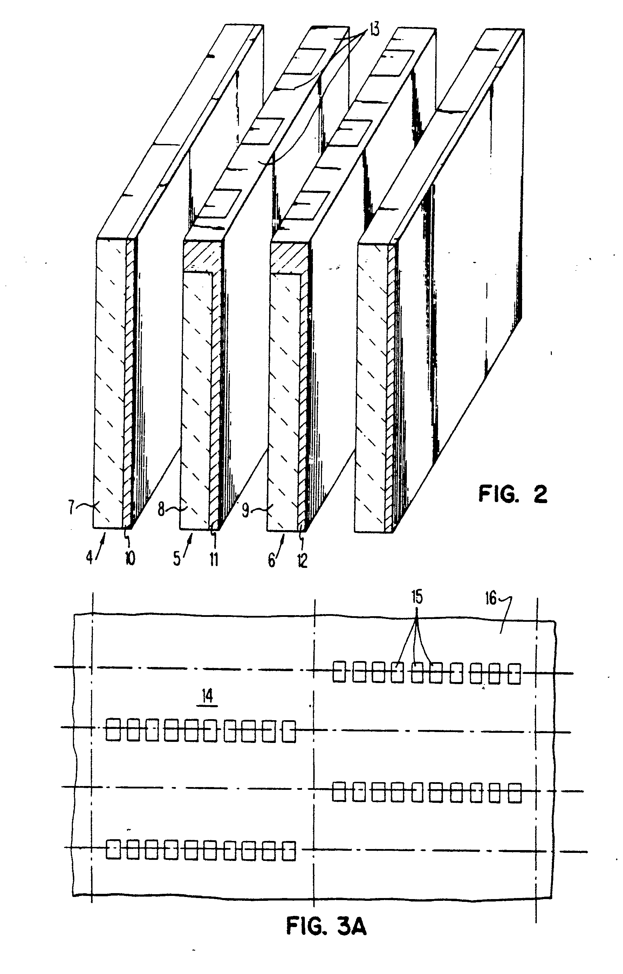

Die Platten 4, 5 und 6 bestehen aus relativ dünnen dielektrischen Schichten 7, 8 und 9 aus keramischem Material, also beispielsweise aus Bariumtitanat. Jede dieser dielektrischen Schichten ist mit einer Schicht 10, 11 und 12 aus leitendem Material belegt, beispielsweise aus Silberpalladium. Die oberen Ränder der Platten 5 und 6 sind ausgestanzt. Die ausgestanzten Gebiete sind mit einer leitenden Masse 13 aufgefüllt, so daß die leitenden Schichten 10, 11 und 12 miteinander elektrisch zu einer Gruppe verbunden sind. Die Explosionszeichnung der Gruppe vor der Vereinigung ist in Fig. 2 dargestellt. Die Vereinigung erreicht man durch Stapeln, Zusammenpressen und Sintern der Schichten.

In einem typischen Beispiel beträgt die Dicke der keramischen Platten etwa 50 bis 65 μm und die Dicke der leitenden Schichten etwa 12,5 μm.

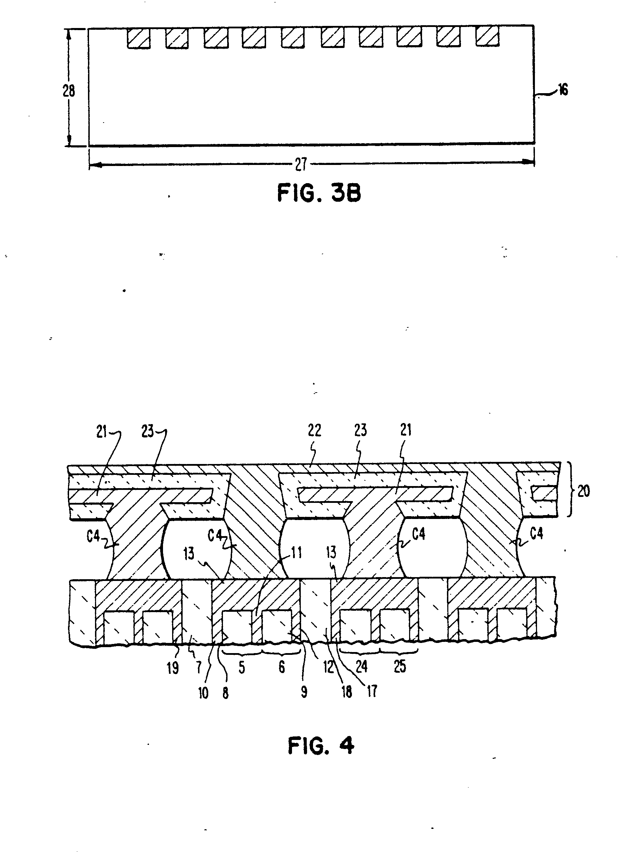

Die Platten werden aus einer größeren Platte 14 aus keramischem Material ausgeschnitten, wie es in Fig. 3A angedeutet ist. Dabei werden rechteckförmige Gebiete 15 in einer Größe von etwa 150 × 500 μm aus der Platte ausgestanzt. Auf die gestanzte Platte 14 wird die leitende Masse in der gewünschten Dicke aufgerieben, wobei gleichzeitig die ausgestanzten Gebiete 15 aufgefüllt werden. Anschließend wird die Platte 14 entlang der strichpunktierten Linien in Einzelplatten 16 der angestrebten Größe zerschnitten. Eine solche Platte ist in Fig. 3B dargestellt.

Betrachtet man nunmehr wiederum die Fign. 1 und 1A, so erkennt man, daß zusätzliche Gruppen von den Platten 4, 5 und 6 entsprechenden Platten Gestapelt, zusammengepreßt und gesintert werden. Der auf diese Weise gebildete Kondensator 1 von Fig. 1 besteht somit aus einer Mehrzahl von Teilkondensatoren, die in noch zu beschreibender Weise parallel verbunden sind. Einer der Teilkondensatoren besteht aus der leitenden Schicht 12, der leitenden Schicht 17 und der dazwischenliegenden dielektrischen Schicht 18. Ein benachbarter Teilkondensator besteht aus den leitenden Schichten 19 und 10 und der dazwischenliegenden dielektrischen Schicht 7. Da elektrische Verbindungen zu jedem Teilkondensator über die leitenden Gebiete 13 an den oberen Rändern der leitenden Schichten hergestellt werden, fließen der Ladestrom und der Entladestrom jedes Kondensators jeweils in entgegengesetzter Richtung, wie es durch die Pfeile in Fig. 1A angedeutet ist. Ein derartiger Stromfluß in den dicht beieinander angeordneten Kondensatorplatten bewirkt eine Auslöschung der damit verbundenen induktiven Felder, so daß die interne Induktivität jedes Kondensators reduziert wird.

Die interne Induktivität jedes Teilkondensators wird verringert, wenn die Dicke der dielektrischen Schichten, beispielsweise der Schichten 7 und 18, reduziert wird und wenn die Länge 27 der Platten vergrößert wird. Will man eine minimale interne Induktivität erreichen, so ist unter Berücksichtigung des Herstellungsverfahrens und der gewünschten Gesamtkapazität eine minimale Höhe 28 jeder Platte anzustreben. In einem Typischen Beispiel werden Platten mit einer Länge von 2500 µm und einer Höhe von 1250 µm verwendet.

Die Art und Weise des Zusammenschaltens der leitenden Gebiete 13, um dadurch die gewünschte Gesamtkapazität zu erreichen, ergibt sich aus der Fig. 4. Die Teilkondensatoren entsprechen denen der Fign. 1A und 2 und sind mit denselben Bezugzeichen versehen. Auf jedem der Gebiete 13 sind Lötperlen C4 angeordnet, die nach ihrem Aufschmelzen die Kondensatorplatten mit einer Anschlußstruktur 20 verbinden. Diese Anschlußstruktur 20 des Kondensators setzt sich aus einer ersten leitenden Schicht 21 und einer zweiten leitenden Schicht 22 zusammen, wobei beide Schichten durch eine Isolationsschicht 23 getrennt sind. Die leitende Schicht 21 und die Isolationsschicht 23 weisen über den aufeinanderfolgenden Gruppen von Platten, also beispielsweise der Gruppe bestehend aus den Platten 5 und 6, Öffnungen auf, um über die Lötperlen C4 die leitende Verbindung zwischen der oberen leitenden Schicht 22 und den zugeordneten leitenden Gebieten 13 der Platten 5 und 6 herstellen zu können. Die absechselnd dazwischenliegenden Gruppen von Platten, also beispielsweise die aus den Platten 24 und 25 bestehende Gruppe, sind in entsprechender Weise mit der unteren leitenden Schicht 21 über die Lötperlen C4 verbunden.

Vorzugsweise werden die Lötperlen C4 unter Verwendung einer zusätzlichen Aufdampfmaske auf die leitenden Gebiete 13 aufgedampft. Für diesen Zweck weist die Aufdampfmaske in matrixförmiger Anordnung Öffnungen auf, die mit den ebenfalls in Matrixform angeordneten leitenden Gebieten 13, wie es in Fig. 1 dargestellt ist, zur Deckung kommen. Diese Aufdampfmaske wird vor Durchführung des Aufdampfprozesses auf die obere Oberfläche der Struktur des Kondensators 1 gemäß Fig. 1 aufgepresst und gesintert. Die Aufdampfmaske kann nach dem Aufdampfprozeß während des Aufschmelzens der Lötperlen C4 dazu dienen, einen unkontrollierten Lötmittelfluß zwischen den Gebieten 13 entlang der Kanten der leitenden Schichten 10, 11 und 12 zu verhindern.

## Patentansprüche

1. Dickschicht-Kondensator mit mehreren, jeweils durch eine dielektrische Schicht (7, 18) getrennten, leitenden Kondensatorplatten (10, 12, 17, 19), von denen die einem mit einem ersten Anschluß und die anderen mit einem zweiten Anschluß verbunden sind, wobei der erste Anschluß aus einer ersten und der zweite Anschluß aus einer zweiten, von der ersten durch eine Isolationsschicht (23) getrenneň, leitenden Schicht (21, 22) besteht, sich die beiden Schichten (21, 22) im wesentlichen senkrecht zu den Konsensatorplatten (10, 12, 17, 19) erstrecken und die Kondensatorplatten (10, 12, 17, 19) jeweils über die gleiche Kante so mit der ersten bzw. zweiten leitenden Schicht (21, 22) leitend verbunden sind, daß die im Betrieb auftretenden Verschiebungsströme in jeweils benachbarten Kondensatorplatten in entgegengesetzter Richtung fließen, dadurch gekennzeichnet, daß die leitende Verbindung zwischen den Kanten der Kondensatorplatten (10, 12, 17, 19) und den die Anschlüsse bildenden Leitenden Schichten (21, 22) aus in Zeilen und dazu senkrechten Spalten parallel zueinander verlaufenden leitenden Zwischenstücken (C4) gebildet sind und daß die aufeinanderfolgenden Kondensatorplatten (10, 12, 17, 19) abwechselnd mit der ersten und der zweiten leitenden Schicht (21, 22) verbunden sind.

2. Dickschicht-Kondensator nach Anspruch 1, dadurch gekennzeichnet, daß die dielektrischen Schichten aus Bariumtitanat als Grundmaterial und die leitenden Schichten aus einer Masse aus Silber-Palladium bestehen.

3. Dickschicht-Kondensator nach den Ansprüchen 1 und 2, dadurch gekennzeichnet, daß die Kondensatorplatten (10, 12, 17, 19) einen Abstand von 25 bis 80 µm haben.

## Revendications

1. Condensateur à couches épaisses comportant plusieurs plaques conductrices (10, 12, 17, 19), respectivement séparées par une couche diélectrique (7, 18), et parmi lesquelles certaines plaques sont reliées à une première borne et les autres à une seconde borne, et dans lequel la première borne est constituée par une première couche conductrice (21) et la seconde borne est constituée par une seconde couche conductrice (22) séparée de la première par une couche isolante (23), les deux couches (21, 22) s'étendent essentiellement perpendiculairement aux plaques (10, 12, 17, 19) du condensateur, et les plaques (10, 12, 17, 19) du condensateur sont réunies de façon conductrice, respectivement par l'intermédiaire du même bord, à la première ou à la seconde couche conductrice (21, 22) de telle sorte que les courants de déplacement, qui apparaissent en cours de fonctionnement circulent en sens opposé dans des plaques respectivement voisines du condensateur, caractérisé en ce que la liaison conductrice entre les bords des plaques (10, 12, 17, 19) du condensateur et les couches conductrices (21, 22) constituant les bornes est formée par des éléments intercalaires conducteurs (C4) s'étendant parallèlement les uns aux autres suivant des lignes et suivant des colonnes perpendiculaires à ces dernières, et que les plaques (10, 12, 17, 19) successives du condensateur sont reliées en alternance aux première et seconde couches conductrices (21, 22).

2. Condensateur à couches épaisses selon la revendication 1, caractérisé en ce que les couches diélectriques sont constituées par du titanate de barium comme matériau de base et les couches conductrices sont constituées par une masse d'argent-palladium.

3. Condensateur à couches épaisses selon les revendications 1 et 2, caractérisé en ce que les plaques (10, 12, 17, 19) du condensateur sont à une distance réciproque comprise entre 25 et 80 μm.

**Claims**

1. Thick film capacitor with several conductive capacitor plates (10, 12, 17, 19) respectively separated by a dielectric layer (7, 18), some of said plates being connected to a first connection, and the remainder to a second connection, the first connection consisting of a first conductive layer (21, 22), and the second connection of a second conductive layer (21, 22) separated from the first one by an insulation layer (23), and the two layers (21, 22) extending substantially vertically to the capacitor plates (10, 12, 17, 19), said capacitor plates (10, 12, 17, 19) being conductively connected to the first and second conductive layer (21, 22), respectively, over the same respective edge in such a manner that the displacement currents appearing in operation flow in opposite direction in respectively adjacent capacitor plates, characterized in that the conductive connection between the edges of the capacitor plates (10, 12, 17, 19) and the conductive layers (21, 22) forming the connections consist of conductive intermediate units (C4) extending in parallel to each other in rows and in columns provided vertically thereto, and in that the capacitor plates (10, 12, 17, 19) placed one upon the other are alternatingly connected to the first and the second conductive layer (21, 22).

2. Thick film capacitor as claimed in claim 1, characterized in that the dielectric layers consist of barium titanate as a base material, and in that the conductive layers consist of a silver palladium substance.

3. Thick film capacitors as claimed in claims 1 and 2, characterized in that the capacitor plates (10, 12, 17, 19) are spaced by 25 to 80 μm.

FIG. 1

FIG. 1A

FIG. 2

FIG. 3A

FIG. 3B

FIG. 4